# EUROPEAN PATENT SPECIFICATION

(11) **EP 2 901 292 B1**
(45) Date of publication and mention of the grant of the patent: **21.11.2018**
(21) Application number: 13841142.6
(22) Date of filing: 24.06.2013
(51) Int. Cl.: G06F 12/16, G06F 11/10, G11C 16/06, G06F 12/02, G11C 16/34, G11C 16/10

(54) **TECHNIQUES ASSOCIATED WITH PROTECTING SYSTEM CRITICAL DATA WRITTEN TO NON-VOLATILE MEMORY**
TECHNIKEN IN VERBINDUNG MIT DEM SCHUTZ VON AUF EINEN NICHTFLÜCHTIGEN SPEICHER GESCHRIEBENEN KRITISCHEN SYSTEMDATEN
TECHNIQUES ASSOCIÉES À LA PROTECTION DE DONNÉES CRITIQUES POUR LE SYSTÈME ÉCRITES DANS UNE MÉMOIRE NON VOLATILE

(30) Priority: 26.09.2012 US 201213627407
(43) Date of publication of application: 05.08.2015
(73) Proprietor: Intel Corporation, Santa Clara, CA 95054 (US)
(72) Inventor: PANGAL, Kiran, Fremont, CA 94536 (US); MOTWANI, Ravi H., San Diego, CA 92128 (US); DAMLE, Prashant S., Portland, OR 97229 (US)
(74) Representative: Rummler, Felix
(86) International application number: PCT/US2013/047442
(87) International publication number: WO 2014/051775

(56) References cited:
- US-A- 5 768 296
- US-A1- 2003 041 300
- US-A1- 2009 241 009
- US-A1- 2010 275 038
- US-A1- 2010 287 433
- US-A1- 2010 313 100
- US-A1- 2011 213 945
- US-A1- 2012 039 123
- US-A1- 2012 079 351
- US-A1- 2012 079 352
- US-A1- 2012 173 955
- US-B1- 7 079 422
- US-B2- 7 719 890
- US-B2- 8 032 497
- MING-FONG TSAI ET AL: "Concurrent multipath transmission combining forward error correction and path interleaving for video streaming", COMPUTER COMMUNICATIONS., vol. 34, no. 9, 1 June 2011 (2011-06-01), pages 1125-1136, XP055255674, NL ISSN: 0140-3664, DOI: 10.1016/j.comcom.2010.02.001

## Description

### BACKGROUND

Computing devices may include the use of types of memory devices such as a two level memory (2LM) device or a solid state drive (SSD) device. These types of memory devices may include non-volatile memories such as NAND flash memory, NOR flash memory or phase change memory. Often system critical data such as a firmware image for the computing device and/or memory device may be stored in the non-volatile memory. If this system critical data should become corrupted (e.g., uncorrectable errors) the computing device or the memory device may be rendered non-functional (e.g., lockup). Physical mechanisms associated with non-volatile memory may lead to data retention issues. For example, charge loss in NAND flash memories may result in data retention issues. Drift or crystallization in phase change memory may also result in data retention issues.

US 2011/213945 A1 describes a method and system pertaining to the features of the preamble of claim 1.

US 2012/173955 A1, US 2012/079351 A1, US 2010/313100 A1 and MING-FONG TSAI ET AL, "Concurrent multipath transmission combining forward error correction and path interleaving for video streaming", COMPUTER COMMUNICATIONS., NL, (20110601), vol. 34, no. 9, doi:10.1016/j.comcom.2010.02.001, ISSN 0140-3664, pages 1125 - 1136, XP055255674, describe systems and methods for improving error correcting coding.

US 2010/287433 A1, US 2009/241009 A1, US 2003/041300 A1, US 7079422 B1, US 2012/039123 A1, US 2010/275038 A1, US 7719890 B2, US 2012/079352 A1, US 8032497 B2 and US 5768296 A describe systems and methods pertaining to the technological background of the present invention.

### Summary of the Invention

The present invention is defined in the appended independent claims to which reference should be made. Advantageous features are set out in the appended dependent claims.

### BRIEF DESCRIPTION OF THE DRAWINGS

- FIG. 1: illustrates an example memory system.
- FIG. 2: illustrates example first data formats.
- FIG. 3: illustrates example second data formats.
- FIG. 4: illustrates example third data formats.
- FIG. 5: illustrates non-claimed example fourth data formats.
- FIG. 6: illustrates example fifth data formats.
- FIG. 7: illustrates example drift timers.
- FIG. 8: illustrates an example multiple pulse-verification process.
- FIG. 9: illustrates an example apparatus.
- FIG. 10: illustrates an example logic flow.
- FIG. 11: illustrates an example storage medium.
- FIG. 12: illustrates an example computing platform.

### DETAILED DESCRIPTION

As contemplated in the present disclosure, physical mechanisms or random errors associated with non-volatile memory may lead to data retention issues for system critical data. User data that includes non-system critical data may face the same data retention issues. However, data corruption in user data may be unlikely to cause a computing or memory device to become non-functional. Therefore, a higher tolerance for data corruption may be allowed for user data as compared to system critical data. Typically, due to the lower tolerance for errors, system critical data may have additional levels of protection compared to user data. The additional levels of protection attempt to eliminate or substantially reduce the impact of at least some data corruption potentially caused by physical mechanisms associated with non-volatile memories or from random errors.

In some examples, the additional levels of protection for system critical data may include storing multiple copies of system critical data for redundancy. In examples where multi-level cell (MLC) technology is used (such as for NAND flash memories), the additional levels of protection may include storing or writing system critical data in a single-level cell (SLC) format. For these examples, storing system critical data in an SLC format may increase retention margins as compared to storing in an MLC format.

Even if the use of more memory capacity is acceptable for protecting system critical data, physical mechanisms that cause data corruption issues may vary between types of volatile memories. For example, in NAND flash memory, data retention mechanisms are negatively impacted as write cycles to this type of non-volatile memory increase. Since system critical data may not undergo significant write cycling compared to user data, non-volatile memory cells storing the system critical data may naturally have a higher level of protection. But for other types of non-volatile memory such as phase change memory (PCM), PCM and switch (PCMS), nanowire or ferroelectric transistor random access memory (FeTRAM) system critical data may face an increased likelihood of data retention issues when infrequently cycled. For example, system critical data stored in phase change memory cells that are not being cycled have to retain their states for long periods of time without getting "refreshed" as a result of a write cycle. Multiple copies of system critical data may help, but phase change memory physical mechanisms such as drift may cause all copies of system critical data to become corrupted and potentially unrecoverable.

In some examples, data correction errors may be addressed via use of an error correction code (ECC) scheme. Since user data typically has a higher tolerance for errors, a single ECC or data protection scheme for protecting both user data and system critical data may be overdesigned. Further, if separate ECC engines for user and system critical data are designed, these separate ECC engines may require extra hardware elements such as extra logic gates. An overdesigned data protection scheme or separate ECC engines for non-volatile memory may result in wasted resources in order to provide added protection to a relatively small amount of data being written to the non-volatile memory. It is with respect to these and other challenges that the examples described herein are needed.

In some examples, techniques associated with protecting system critical data written to non-volatile memory may be implemented. These techniques may include receiving a first write request for writing system critical data to a non-volatile memory and causing system critical data to be written to the non-volatile memory using a first data protection scheme having a given data format size. The techniques may also include receiving a second write request for writing user data that includes non-system critical data to the non-volatile memory and causing the user data to be written to the non-volatile memory using a second data protection scheme. For these examples, the second data protection scheme may have a same given data format size as system critical data written to the non-volatile memory according to the first data protection scheme.

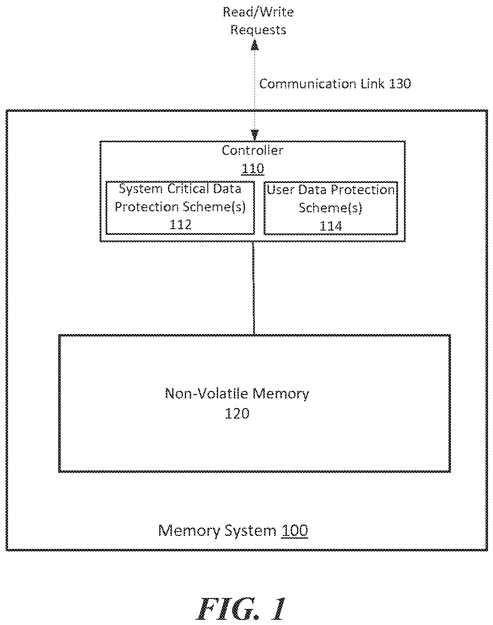

**FIG. 1** illustrates an example memory system 100. As shown in FIG. 1, memory system 100 includes a controller 110, a non-volatile memory 120 and a communication link 130. According to some examples, controller 110 may receive and/or fulfill read/write requests via communication link 130.

Although not shown in FIG. 1, in some examples, communication link 130 may communicatively couple controller 110 to elements or features associated with an operating system for a computing device. In some examples, memory system 100 may functions as a two level memory (2LM) system that serves as main memory for the operating system. For these examples, in addition to non-volatile memory 120, memory system 100 may also include volatile memory (not shown) such as dynamic random access memory (DRAM), or static random access memory (SRAM) that may serve as a first level or near memory of the 2LM system. Non-volatile memory 120 may serve as the second level or far memory of the 2LM system. Non-volatile memory 120 serving as the second level memory may have a substantially larger memory capacity than the volatile types of memory included in the first level memory. Thus, data (e.g., user data and/or system critical data) may be substantially read from and written to memory addresses associated with non-volatile memory cells maintained at non-volatile memory 120.

In other examples, memory system 100 may function as a solid state drive (SSD) device for a computing device. For these examples, communication link 130 may communicatively couple controller 110 to the computing device and enables elements of the computing device to make read/write requests to store data in non-volatile memory 120. The data to be stored at or written to non-volatile memory 120 may include both user data and system critical data.

According to some examples, non-volatile memory 120 may include one or more types of non-volatile memory to include, but not limited to, NAND flash memory, NOR flash memory, phase change memory, ferroelectric memory, silicon-oxide-nitride-oxide-silicon (SONOS) memory, polymer memory such as ferroelectric polymer memory, ferroelectric transistor random access memory (FeTRAM) or FeRAM), ovonic memory or electrically erasable programmable read-only memory (EEPROM).

According to some examples, controller 110 may include logic and/or features to receive a first write request for writing system critical data to non-volatile memory 120. For these examples, controller 110 may cause system critical data to be written to non-volatile memory 120 using a first data protection scheme from among system critical data protection scheme(s) 112. As described in more detail below, system critical data protection scheme(s) 112 may include one or more data protection schemes to provide additional protection to system critical data written to non-volatile memory 120. Also, as mentioned more below, each data protection scheme included in system critical data protection scheme(s) has a given data format size, e.g., a given number of bits.

In some examples, controller 110 may also include logic and/or features to receive a second write request for writing user data to non-volatile memory 120. This user data may include non-system critical data and controller 110 may cause the user data to be written to non-volatile memory 120 using a second data protection scheme from among user data protection scheme(s) 114. For these examples, the second data protection scheme from among user data protection scheme(s) 114 may have a same given data format size as system critical data written to the non-volatile memory according to the first data protection scheme from among system critical data protection scheme(s) 112.

According to some examples, controller 110's use of a same given data format size for both the first and second data protection schemes may allow for a relatively similar amount of resources (e.g., logic gates) to support encoders or decoders used to encode data using these different data protection schemes. In other words, a same ECC engine may be used to support data protection schemes for both protecting user data and protecting system critical data and yet the ECC engine may only require a relatively small amount of additional resources (e.g., buffers) to support at least some of the different data protection schemes.

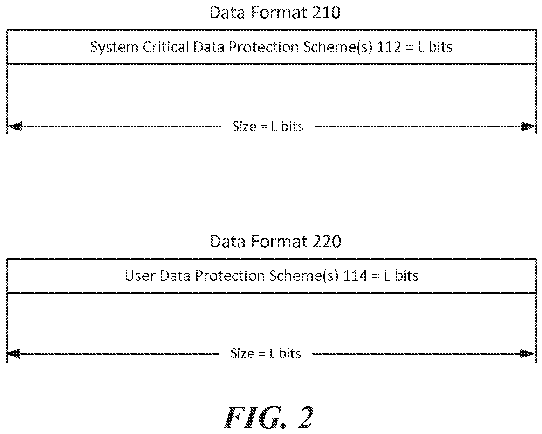

**FIG. 2** illustrates example data formats 210 and 220. In some examples, as shown in FIG. 2, data formats 210 and 220 may both include a given data format size of *L* bits, where *L* equals any positive integer. Also, as shown in FIG. 2, data format 210 may include data associated with system critical data protection scheme(s) 112 and data format 220 may include data associated with user data protection scheme(s) 114. According to some examples, system critical data protection scheme(s) 112 may include encoding system critical data via implementation of various protection schemes such that a total size of the encoded and protected system critical data in the format of example data format 210 is maintained at *L* bits. Also, according to some examples, user data protection scheme(s) 114 may include encoding user data via implementation of various protection schemes such that a total size of the encoded and protected user data in the format of example data format 220 is also maintained at a same given data format size of *L* bits.

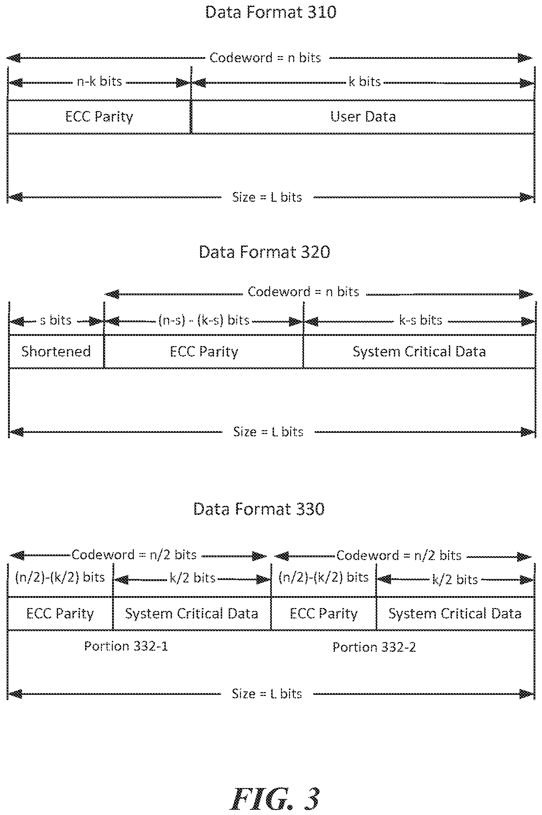

**FIG. 3** illustrates example data formats 310, 320 and 330. In some examples, as shown in FIG. 3, all three data formats have the same given data format size of *L* bits. In some examples, data format 310 may be used for a data protection scheme to protect user data stored to a non-volatile memory such as non-volatile memory 120. For these examples, data formats 320 and 330 may be used for different data protection schemes to protect system critical data stored to the same non-volatile memory.

According to some examples, the data protection schemes to protect the user data included in data format 310 and to protect the system critical data included in data formats 320 and 330 may include use of an ECC (e.g., Reed-Solomon (RS codes) as claimed, or -non-claimed-binary Bose, Chaudhuri, and Hocquenghem (BCH codes)). For these examples, controller 110 may include logic and/or features to use the ECC for user data protection scheme(s) 114 having a code format of (*n,k*), where *n* equals a size of a codeword and *k* equals a size of information to be encoded in *L* bits of data in a data format of example data format 310. Thus, as shown in FIG. 3, *n-k* bits may be used for ECC parity bits that protect *k* bits of user data once the user data is encoded according to user data protection scheme(s) 114.

Also, for examples using the ECC to protect system critical data stored to non-volatile memory 120, controller 110 may include logic and/or features to use the ECC for system critical data protection scheme(s) 112 having a code format of (*n-s,n-k*), where s equals a shortening of the information to be encoded in *L* bits of data in a data format of example data format 320. Thus, as shown in FIG. 3, (*n-s*) - (*k-s*) bits may be used for ECC parity bits that protect *k* bits of system critical data once the system critical data is encoded according to system critical data protection scheme(s) 112. In other words, by shortening the amount of information protected, but using the same number of parity bits, a higher level of protection may be provided to the system critical data.

According to some examples, a number of shortened bits s included in the *L* bits of data in the example format of data format 320 may be indicated to a decoder (e.g., located with controller 110) for the decoder to determine which bits include the encoded information stored at non-volatile memory 120. The indication may include a flag indication to the decoder that may indicate system critical data is included in the *L* bits of data and may also indicate values for *n*, *k* and *s*. For these examples, if the *s* bits are placed on the left of data format 320, the decoder may then determine which bits of the *L* bits of data need to be decoded and which bits may be ignored or masked.

Also, for examples using the ECC to protect system critical data stored to non-volatile memory 120, controller 110 may include logic and/or features to use the ECC for system critical data protection scheme(s) 112 having a code format of (*n*/2,*k*/2), where information in this code format may be encoded in a portion 332-1 and the same information may be redundantly encoded in a portion 332-2. For these examples, portion 332-1 and portion 332-2 may encode a total of *L* bits of data in a data format of example data format 320. The redundantly encoded system critical data may allow for a higher level of protection. Some additional memory capacity may be used by this redundancy but the higher level of protection for system critical data may justify the additional memory capacity usage.

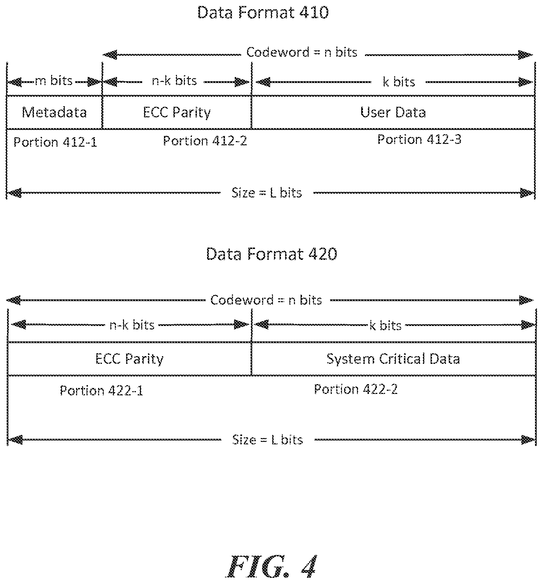

**FIG. 4** illustrates example data formats 410 and 420. In some examples, as shown in FIG. 4, both data formats have the same given data format size of *L* bits. In some examples, data format 410 may be used for a data protection scheme to protect user data stored to a non-volatile memory such as non-volatile memory 120 that also includes some metadata for wear management (e.g., a write count). For these examples, data format 420 may be used for a different data protection scheme to protect system critical data stored to the same non-volatile memory. Since system critical data may only be occasionally accessed, wear management may not be needed and the metadata is shown to be eliminated in FIG. 4 for data format 420.

According to some examples, the data protection schemes to protect the user data included in data format 410 and to protect the system critical data included in data format 420 may include use of an ECC (e.g., the claimed RS codes or the non-claimed binary BCH codes). For these examples, controller 110 may include logic and/or features to use the ECC for user data protection scheme(s) 114 having a code format of (*n,k*), where *n* equals a size of a codeword and *k* equals a size of information to be encoded. The codeword of size *n* may then be combined with *m* bits of metadata to form *L* bits of total data in a data format of example data format 410. Thus, portions 412-1, 412-2 and 412-3 of data format 410 include metadata bits, ECC parity bits and user data bits, respectively.

In some examples, by eliminating metadata in data format 420, additional ECC parity bits may be used to provide a higher level of protection for system critical data compared to user data protected using data format 410. For these examples, controller 110 may include logic and/or features to use the ECC for system critical data protection scheme(s) 112 having a code format of (*n,k*), where *n* equals a size of a codeword and *k* equals a size of information to be encoded in *L* bits of data in a data format of example data format 420. As shown in FIG. 4, *n-k* bits may be used for ECC parity bits that protect *k* bits of system critical data once the system critical data is encoded according to system critical data protection scheme(s) 112. Thus, portions 422-1 and 422-2 of data format 420 include ECC parity bits and user data bits, respectively.

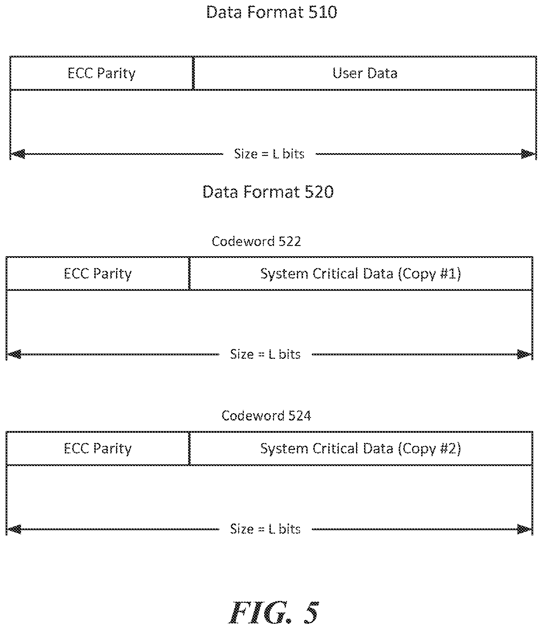

**FIG. 5** illustrates non-claimed example data formats 510 and 520. In some examples, as shown in FIG. 5, data formats 510 and 520 may both include a given data format size of *L* bits. However, to provide a higher level of protection for system critical data, data format 520 may encode copies of system critical data in separate codewords 522 and 524.

According to some examples, the data protection schemes to protect user data included in data format 510 or the system critical data included in data format 520 may include use of an ECC (e.g., RS codes or binary BCH codes). Although some additional memory capacity may be used due to the redundant copies of the system critical data, higher level of protection for system critical data may justify the additional memory capacity usage associated with data format 520. Also, for some examples, the non-volatile memory may be designed such that even with redundant copies, the memory capacity utilized for system critical data may be substantially smaller than the memory capacity still available to store user data.

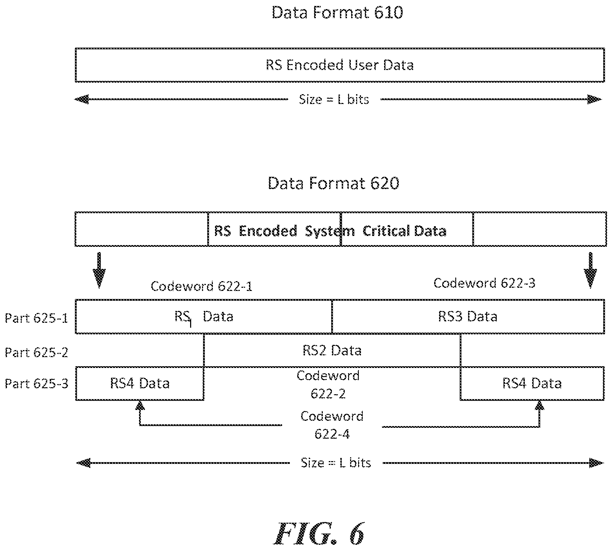

**FIG. 6** illustrates example data formats 610 and 620. In some examples, as shown in FIG. 6, both data formats have the same given data format size of *L* bits. According to some examples, data format 610 may include data associated with user data protection scheme(s) 114 and data format 620 may include data associated with system critical data protection scheme(s) 112.

In some claimed examples, system critical data protection scheme(s) 112 may include use of an ECC based on RS codes. For these examples, in order to provide even greater protection for system critical data compared to possibly replicating system critical data, four separate RS codes may be used as shown in FIG. 6 for data format 620. The four separate RS codes included in codewords 622-1 to 622-4 may include overlapping system critical data as shown in FIG. 6. Therefore, if an unrecoverable error results for system critical data encoded in codewords 622-1 and 622-2 using RS1 and RS2 then the system critical data may still be recovered if the system critical data encoded in codewords 621-3 and 621-4 using RS3 and RS4 is error free or recoverable.

According to some examples, as shown in FIG. 6, codewords 622-1 to 622-4 may be arranged in data format 620 in three parts. These three parts are shown in FIG. 6, as 625-1, 625-2 and 625-3. In order to maintain the given data format size of *L* bits, some of these parts may include filler bits that may be ignored or masked when a codeword is decoded. For example, parts 625-2 and 625-3 may include masked bits while part 625-1 may not include masked bits.

In some examples, controller 110 may include logic and/or features to protect system critical data using data format 620 when writing to non-volatile memory 120. For these examples, controller 110 may include at least some buffering capabilities to at least temporarily store intermediate/overlapping system critical data received in parts 625-1 to 625-3 to enable recovery from errors as mentioned above.

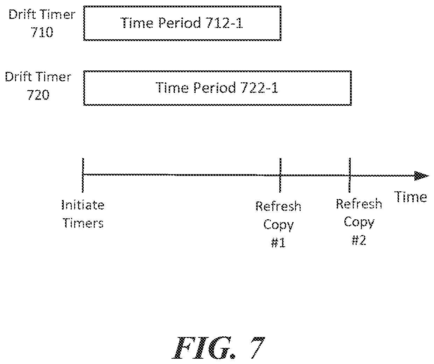

**FIG. 7** illustrates example drift timers 710 and 720. In some examples, as shown in FIG. 7, drift timer 710 includes time period 712-1. Also, drift timer 720 is shown as including time period 722-1. According to some examples, system critical data protection scheme(s) 112 may include writing first and second copies of system critical data to a non-volatile memory such as non-volatile memory 120 (e.g., using data format 520). The first copy (copy #1) may be associated with drift timer 710 and the second copy (copy #2) may be associated with drift timer 720. As shown in FIG. 7, time period 712-1 is different than time period 722-1.

According to some examples, controller 110 may include logic and/or features to maintain both drift timers 710 and 720. For these examples, once copy #1 and copy #2 of the system critical data are written to non-volatile memory 120, both timers may be initiated. As shown in FIG. 7, copy #1 may be refreshed at the expiration of time period 712-1 and copy # 2 may be refreshed at the expiration of time period 722-1. In some examples, both timers may be reset and subsequent refreshes for the copies of the system critical data may occur upon expiration of these reset timers.

In some examples, time periods 712-1 and 722-1 may be set such that copy #1 and copy #2 are refreshed at staggered times. The staggering of the time periods may address physical mechanisms associated with some types of non-volatile memory that may work against each other. For example, drift vs. crystallization or drift vs. read disturb may be physical mechanisms working against each other for types of non-volatile memory such as phase change memory.

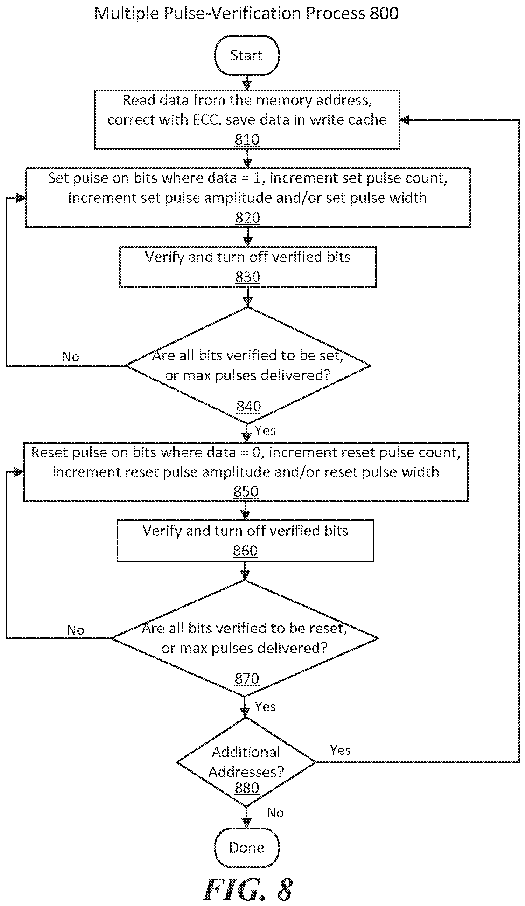

**FIG. 8** illustrates an example multiple pulse-verification process 800. In some examples, controller 110 may include logic and/or features to use multiple pulse-verification process 800 as a way to further protect system critical data stored to non-volatile memory 120 and may be considered a data protection scheme selected from among system critical data protection scheme(s) 112. In some examples, system critical data may have first been written to non-volatile memory cells included in non-volatile memory 120 in a similar manner as user data. However, as described more below, controller 110 may implement multi pulse-verification process 800 to possibly reduce errors by narrowing threshold voltage (Vt) distributions for memory cells associated with the non-volatile memory 120 that are used to store system critical data.

Moving from the start to block 810, controller 110 may include logic and/or features to cause data to be read from a memory address associated with a memory cell at non-volatile memory 120 where system critical data is stored. Once the data is read from the non-volatile memory cell, possible errors associated with the data may be corrected using an ECC scheme that may have been used to write the system critical data to the memory cell (e.g., RS codes or binary BCH codes).

According to some examples, controller 110 may include logic and/or features to cause the error corrected data to be at least temporarily saved to a write cache maintained by controller 110.

Proceeding from block 810 to block 820, controller 110 may include logic and/or features to cause a multi pulse-verification algorithm to be used that starts at block 820. The multi pulse-verification algorithm may be used in order to narrow cell Vt distributions for the memory cell at non-volatile memory 120. In some examples, a set pulse may be asserted on bits for the memory cell where data = 1. A set pulse count may then be incremented, a set pulse amplitude and/or a set pulse width may also be incremented.

Proceeding from block 820 to block 830, controller 110 may include logic and/or features to cause the corrected data in the write cache to be used to verify bits for the memory cell where data = 1 and then cause verified bits to be turned off.

Proceeding from block 830 to decision block 840, controller 110 may include logic and/or features to determine whether all bits have been verified to be set (e.g., written back to the memory cell) or maximum pulses delivered. If all bits for the memory cell have been verified to be set or maximum pulses delivered, the process moves to block 850. Otherwise the process moves to block 820.

Moving from decision block 840 to block 850, controller 110 may include logic and/or features to cause the continued use of the multi pulse-verification algorithm that started at block 820 in order to narrow cell Vt distributions for the memory cell. In some examples, a reset pulse may be asserted on bits for the memory cell where data = 0. A reset pulse count may then be incremented, a reset pulse amplitude and/or a reset pulse width may also be incremented.

Proceeding from block 850 to block 860, controller 110 may include logic and/or features to cause the corrected data write cache to be used to verify bits for memory cell where data = 0 and then cause verified bits to be turned off.

Proceeding from block 860 to decision block 870, controller 110 may include logic and/or features to determine whether all bits have been verified to be reset (e.g., written back to the memory cell) or maximum pulses delivered. If all bits for the memory cell have been verified to be reset or maximum pulses delivered, the process moves to decision block 880. If all the bits have not been verified to be reset or maximum pulses delivered, the process moves to block 850.

Moving from decision block 870 to decision block 880, controller 110 may determine whether additional memory addresses of non-volatile memory 120 storing the system critical data still need to go through multiple pulse-verification process 800. If additional memory addresses still need to go through multiple pulse-verification process 800, the process moves to block 810. Otherwise, the process is done.

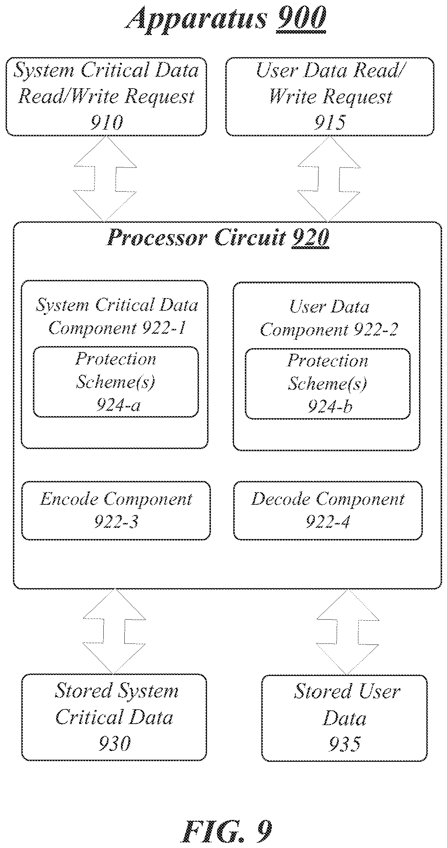

**FIG. 9** illustrates an example apparatus 900. Although the apparatus 900 shown in FIG. 9 has a limited number of elements in a certain topology, it may be appreciated that the apparatus 900 may include more or less elements in alternate topologies as desired for a given implementation.

The apparatus 900 may comprise a computer-implemented apparatus that may include at least some of the logic and/or features mentioned above for controller 110 for FIGS. 1-8. The computer-implemented apparatus 900 may be arranged to execute one or more software components 922-*a.* It is worthy to note that "*a*" and "*b*" and "*c*" and similar designators as used herein are intended to be variables representing any positive integer. Thus, for example, if an implementation sets a value for *a* = 5, then a complete set of software components 922-*a* may include modules 922-1, 922-2, 922-3, 922-4 or 922-5. The embodiments are not limited in this context.

According to some examples, apparatus 900 may be capable of being located with a computing device and may be part of a memory system such as memory system 100 (e.g., controller 110). For these examples, apparatus 900 may be included in or implemented by a processor or processor circuitry. In other examples, apparatus 900 may be implemented as part of firmware (e.g., BIOS), or implemented as a middleware application. The examples are not limited in this context.

In some examples, if implemented in a processor, the processor may be generally arranged to execute one or more software components 922-*a*. The processor can be any of various commercially available processors, including without limitation an AMD® Athlon®, Duron® and Opteron® processors; ARM® application, embedded and secure processors; IBM® and Motorola® DragonBall® and PowerPC® processors; IBM and Sony® Cell processors; Intel® Celeron®, Core (2) Duo®, Core i3, Core i5, Core i7, Pentium®, and XScale® processors; and similar processors. Multi-core processors and other multi-processor architectures may also be employed to implement apparatus 900.

According to some examples, apparatus 900 may include a system critical data component 922-1. System critical data component 922-1 may be arranged for execution by processor circuit 920 to receive a write request included in system critical data read/write request 910. For these examples, the write request may be for writing system critical data to a non-volatile memory such as non-volatile memory 120. System critical data component 922-1 may also be arranged to cause the system critical data to be written to non-volatile memory 120 using protection scheme(s) 924-a having a given data format size. In some examples, protection scheme(s) 924-a may include one or more of the protection schemes mention above for FIGS. 2-8. Instructions for implementing these protection scheme(s) 924-a may be at least temporarily maintained by system critical data component 922-1, e.g., stored in a data structure such as a lookup table (LUT).

In some examples, apparatus 900 may also include a user data component 922-2. User data component 922-2 may be arranged for execution by processor circuit 920 to receive a write request included in user data read/write request 915. For these examples, the write request may be for writing user data to non-volatile memory 120. User data component 922-2 may also be arranged to cause the user data to be written to non-volatile memory 120 using protection scheme(s) 924-b having a same given data format size as system critical data written to non-volatile memory 120 by system critical data component 922-1. In some examples, protection scheme(s) 924-b may also include one or more of the protection schemes mention above for FIGS. 2-8. Instructions for implementing these protection scheme(s) 924-b may be at least temporarily maintained by user data component 922-2, e.g., stored in a data structure such as a LUT.

In some examples, apparatus 900 may also include an encode component 922-3. Encode component 922-3 may be arranged for execution by processor circuit 920 to encode system critical data according to protection scheme(s) 924-a having a given data format size. The encoded system critical data may be stored at non-volatile memory 120 as stored system critical data 930. Encode component 922-3 may also be arranged to encode user data according to protection scheme(s) 924-b having the same given data format size used from protection scheme(s) 924-a to encode the system critical data. The encoded user data may be stored at non-volatile memory 120 as stored user data 935.

According to some examples, apparatus 900 may also include a decode component 922-4. Decode component 922-4 may be arranged for execution by processor circuit 920 to decode encoded stored system critical data 930 responsive to a read request included in a received system critical data read/write request 910. Decode component 922-4 may also decode encoded stored user data 935 responsive to a read request included in a received user data read/write request 915.

Included herein is a set of logic flows representative of example methodologies for performing novel aspects of the disclosed architecture. While, for purposes of simplicity of explanation, the one or more methodologies shown herein are shown and described as a series of acts, those skilled in the art will understand and appreciate that the methodologies are not limited by the order of acts. Some acts may, in accordance therewith, occur in a different order and/or concurrently with other acts from that shown and described herein. For example, those skilled in the art will understand and appreciate that a methodology could alternatively be represented as a series of interrelated states or events, such as in a state diagram. Moreover, not all acts illustrated in a methodology may be required for a novel implementation.

A logic flow may be implemented in software, firmware, and/or hardware. In software and firmware embodiments, a logic flow may be implemented by computer executable instructions stored on at least one non-transitory computer readable medium or machine readable medium, such as an optical, magnetic or semiconductor storage. The embodiments are not limited in this context.

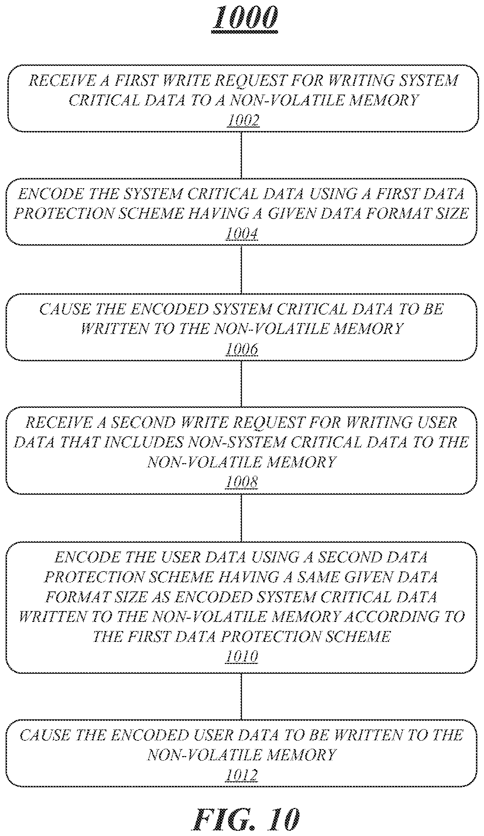

**FIG. 10** illustrates a logic flow 1000. Logic flow 1000 may be representative of some or all of the operations executed by one or more logic, features, or devices described herein, such as apparatus 900 that may be included with or be a part of a controller for a memory system such as memory system 100. More particularly, logic flow 1000 may be implemented by system critical data component 922-1, user data component 922-2, encode component 922-3 or decode component 922-4.

According to some examples, logic flow 1000 may receive a first write request for writing system critical data to a non-volatile memory at block 1002. For these examples, the first write request may be received by system critical data component 922-1 and may be for writing system critical data to non-volatile memory 120 of memory system 100.

In some examples, logic flow 1000 may encode the system critical data using a first data protection scheme having a given data format size at block 1004. For these examples, encode component 922-3 may encode the system critical data according to protection scheme(s) 924-a that have a given data format size of *L* bits as mentioned above for the data formats for FIGS. 2-7.

According to some examples, logic flow 1000 may cause the encoded system critical data to be written to the non-volatile memory at block 1006. For these examples, either system critical data component 922-1 or encode component 922-3 may cause the encoded system critical data to be written to non-volatile memory 120.

In some examples, logic flow 1000 may receive a second write request for writing user data that includes non-system critical data to the non-volatile memory at block 1008. For these examples, the second write request may be received by user data component 922-2 and may be for writing user data to non-volatile memory 120. Also, the user data may include non-system critical data.

According to some examples, logic flow 1000 may encode the user data using a second data protection scheme having a same given data format size as encoded system critical data written to the non-volatile memory according to the first data protection scheme at block 1010. For these examples, encode component 922-3 may encode the user data according to protection scheme(s) 924-b that also have a same given data format size of *L* bits.

In some examples, logic flow 100 may cause the encoded user data to be written to the non-volatile memory at block 1012. For these examples, either user data component 922-2 or encode component 922-3 may cause the encoded system critical data to be written to non-volatile memory 120.

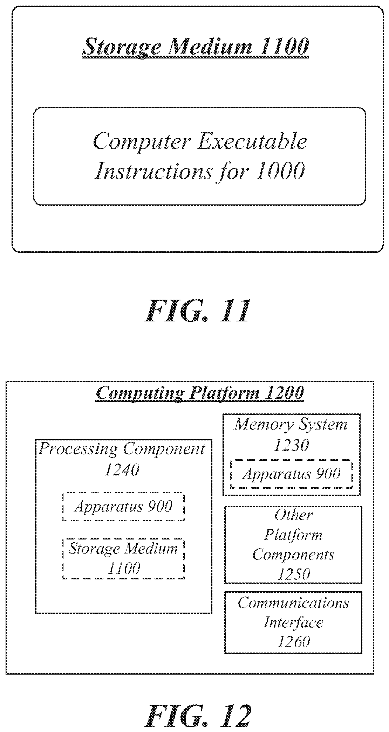

**FIG. 11** illustrates an embodiment of a storage medium 1100. The storage medium 1100 may comprise an article of manufacture. In some examples, storage medium 1100 may include any non-transitory computer readable medium or machine readable medium, such as an optical, magnetic or semiconductor storage. Storage medium 1100 may store various types of computer executable instructions, such as instructions to implement logic flow 1000. Examples of a computer readable or machine readable storage medium may include any tangible media capable of storing electronic data, including volatile memory or non-volatile memory, removable or non-removable memory, erasable or non-erasable memory, writeable or re-writeable memory, and so forth. Examples of computer executable instructions may include any suitable type of code, such as source code, compiled code, interpreted code, executable code, static code, dynamic code, object-oriented code, visual code, and the like. The examples are not limited in this context.

**FIG. 12** illustrates an example computing platform 1200. In some examples, as shown in FIG. 12, computing platform 1200 may include a memory system 1230, a processing component 1240, other platform components 1250 or a communications interface 1260. According to some examples, computing platform 1200 may be implemented in a computing device.

According to some examples, memory system 1230 may be similar to memory system 100. For these examples, logic and/or features (e.g., included in a controller) resident at or located with memory system 1230 may execute at least some processing operations or logic for apparatus 900. Also, memory system 1230 may include non-volatile memory (not shown) that may be written to or read from in a similar manner as described above for memory system 100 based on the type of data to be written (e.g., user or system critical) and the data protection scheme used.

According to some examples, processing component 1240 may also execute at least some processing operations or logic for apparatus 900 and/or storage medium 1000. Processing component 1240 may include various hardware elements, software elements, or a combination of both. Examples of hardware elements may include devices, logic devices, components, processors, microprocessors, circuits, processor circuits, circuit elements (e.g., transistors, resistors, capacitors, inductors, and so forth), integrated circuits, application specific integrated circuits (ASIC), programmable logic devices (PLD), digital signal processors (DSP), field programmable gate array (FPGA), memory units, logic gates, registers, semiconductor device, chips, microchips, chip sets, and so forth. Examples of software elements may include software components, programs, applications, computer programs, application programs, system programs, software development programs, machine programs, operating system software, middleware, firmware, software modules, routines, subroutines, functions, methods, procedures, software interfaces, application program interfaces (API), instruction sets, computing code, computer code, code segments, computer code segments, words, values, symbols, or any combination thereof. Determining whether an example is implemented using hardware elements and/or software elements may vary in accordance with any number of factors, such as desired computational rate, power levels, heat tolerances, processing cycle budget, input data rates, output data rates, memory resources, data bus speeds and other design or performance constraints, as desired for a given example.

In some examples, other platform components 1250 may include common computing elements, such as one or more processors, multi-core processors, co-processors, memory units, chipsets, controllers, peripherals, interfaces, oscillators, timing devices, video cards, audio cards, multimedia input/output (I/O) components (e.g., digital displays), power supplies, and so forth. Examples of memory units associated with either other platform components 1250 or memory system 1230 may include without limitation, various types of computer readable and machine readable storage media in the form of one or more higher speed memory units, such as ROM, RAM, DRAM, Double-Data-Rate DRAM (DDRAM), synchronous DRAM (SDRAM), SRAM, programmable ROM (PROM), EPROM, EEPROM, NAND flash memory, NOR flash memory, polymer memory such as ferroelectric polymer memory, ferroelectric transistor random access memory (FeTRAM or FeRAM), nanowire, ovonic memory, phase change or ferroelectric memory, SONOS memory, magnetic or optical cards, an array of devices such as Redundant Array of Independent Disks (RAID) drives, solid state memory devices (e.g., USB memory), SSDs and any other type of storage media suitable for storing information.

In some examples, communications interface 1260 may include logic and/or features to support a communication interface. For these examples, communications interface 1260 may include one or more communication interfaces that operate according to various communication protocols or standards to communicate over direct or network communication links. Direct communications may occur via use of communication protocols or standards described in one or more industry standards (including progenies and variants) such as those associated with the System Management Bus (SMBus) specification, the PCI Express specification, the Serial Advanced Technology Attachment (SATA) specification or the Universal Serial Bus (USB) specification. Network communications may occur via use of communication protocols or standards such those described in the Ethernet standard.

Computing platform 1200 may be part of a computing device that may be, for example, user equipment, a computer, a personal computer (PC), a desktop computer, a laptop computer, a notebook computer, a netbook computer, a server, a server array or server farm, a web server, a network server, an Internet server, a work station, a mini-computer, a main frame computer, a supercomputer, a network appliance, a web appliance, a distributed computing system, multiprocessor systems, processor-based systems, or combination thereof. Accordingly, functions and/or specific configurations of computing platform 1200 described herein, may be included or omitted in various embodiments of computing platform 1200, as suitably desired.

The components and features of computing platform 1200 may be implemented using any combination of discrete circuitry, application specific integrated circuits (ASICs), logic gates and/or single chip architectures. Further, the features of computing platform 1200 may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It should be appreciated that the exemplary computing platform 1200 shown in the block diagram of FIG. 12 may represent one functionally descriptive example of many potential implementations. Accordingly, division, omission or inclusion of block functions depicted in the accompanying figures does not infer that the hardware components, circuits, software and/or elements for implementing these functions would necessarily be divided, omitted, or included in embodiments.

One or more aspects of at least one example may be implemented by representative instructions stored on at least one machine-readable medium which represents various logic within the processor, which when read by a machine, computing device or system causes the machine, computing device or system to fabricate logic to perform the techniques described herein. Such representations, known as "IP cores" may be stored on a tangible, machine readable medium and supplied to various customers or manufacturing facilities to load into the fabrication machines that actually make the logic or processor.

Various examples may be implemented using hardware elements, software elements, or a combination of both. In some examples, hardware elements may include devices, components, processors, microprocessors, circuits, circuit elements (e.g., transistors, resistors, capacitors, inductors, and so forth), integrated circuits, application specific integrated circuits (ASIC), programmable logic devices (PLD), digital signal processors (DSP), field programmable gate array (FPGA), memory units, logic gates, registers, semiconductor device, chips, microchips, chip sets, and so forth. In some examples, software elements may include software components, programs, applications, computer programs, application programs, system programs, machine programs, operating system software, middleware, firmware, software modules, routines, subroutines, functions, methods, procedures, software interfaces, application program interfaces (API), instruction sets, computing code, computer code, code segments, computer code segments, words, values, symbols, or any combination thereof. Determining whether an example is implemented using hardware elements and/or software elements may vary in accordance with any number of factors, such as desired computational rate, power levels, heat tolerances, processing cycle budget, input data rates, output data rates, memory resources, data bus speeds and other design or performance constraints, as desired for a given implementation.

Some examples may include an article of manufacture or at least one computer-readable medium. A computer-readable medium may include a non-transitory storage medium to store logic. In some examples, the non-transitory storage medium may include one or more types of computer-readable storage media capable of storing electronic data, including volatile memory or non-volatile memory, removable or non-removable memory, erasable or non-erasable memory, writeable or re-writeable memory, and so forth. In some examples, the logic may include various software elements, such as software components, programs, applications, computer programs, application programs, system programs, machine programs, operating system software, middleware, firmware, software modules, routines, subroutines, functions, methods, procedures, software interfaces, API, instruction sets, computing code, computer code, code segments, computer code segments, words, values, symbols, or any combination thereof.

According to some examples, a computer-readable medium may include a non-transitory storage medium to store or maintain instructions that when executed by a machine, computing device or system, cause the machine, computing device or system to perform methods and/or operations in accordance with the described examples. The instructions may include any suitable type of code, such as source code, compiled code, interpreted code, executable code, static code, dynamic code, and the like. The instructions may be implemented according to a predefined computer language, manner or syntax, for instructing a machine, computing device or system to perform a certain function. The instructions may be implemented using any suitable high-level, low-level, object-oriented, visual, compiled and/or interpreted programming language.

Some examples may be described using the expression "in one example" or "an example" along with their derivatives. These terms mean that a particular feature, structure, or characteristic described in connection with the example is included in at least one example. The appearances of the phrase "in one example" in various places in the specification are not necessarily all referring to the same example.

Some examples may be described using the expression "coupled" and "connected" along with their derivatives. These terms are not necessarily intended as synonyms for each other. For example, descriptions using the terms "connected" and/or "coupled" may indicate that two or more elements are in direct physical or electrical contact with each other. The term "coupled," however, may also mean that two or more elements are not in direct contact with each other, but yet still co-operate or interact with each other.

In addition, in the foregoing Detailed Description, it can be seen that various features are grouped together in a single example for the purpose of streamlining the disclosure. This method of disclosure is not to be interpreted as reflecting an intention that the claimed examples require more features than are expressly recited in each claim. Rather, as the following claims reflect, inventive subject matter lies in less than all features of a single disclosed example. Thus the appended claims are hereby incorporated into the Detailed Description, with each claim standing on its own as a separate example. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

## Claims

1. A method comprising:
receiving (1002) a first write request for writing system critical data to a non-volatile memory (120);
causing (1004, 1006) system critical data to be encoded and written to the non-volatile memory using a first data protection scheme having a given data format size; and
receiving (1008) a second write request for writing user data that includes non-system critical data to the non-volatile memory; **characterised by**
causing (1010, 1012) the user data to be encoded and written to the non-volatile memory using a second data protection scheme having a same given data format size as system critical data written to the non-volatile memory according to the first data protection scheme; and
the first data protection scheme comprising use of a Reed-Solomon error correction code (ECC) that uses four separate Reed-Solomon codewords having overlapping system critical data.

2. The method of claim 1, the non-volatile memory being part of a memory device (100) comprising one of a two level memory (2LM) device or a solid state drive (SSD) device, the system critical data comprising data that if unreadable after being written to the non-volatile memory render the memory device or a computing device (1200) using the memory device non-functional.

3. The method of claim 1, comprising the first data protection scheme and the second data protection scheme both including use of a Reed-Solomon error correction code ECC, the use of the Reed-Solomon ECC for the second data protection scheme having a code format of (n, k), where n equals a size of a codeword and k equals a size of information to be encoded, the use of the Reed-Solomon ECC for the first data protection scheme having a code format of (n-s,k-s), where s equals a shortening of the information to be encoded.

4. The method of claim 1, comprising the first data protection scheme and the second data protection scheme both including use of a Reed-Solomon error correction code ECC, the use of the Reed-Solomon ECC for the second data protection scheme having a first code format of (n, k), where n equals a size of a codeword and k equals a size of information to be encoded, the use of the Reed-Solomon ECC for the first data protection scheme having a second code format of (n/2,k/2), where information in the second code format is encoded in a first portion and the same information is redundantly encoded in a second portion.

5. The method of claim 1, the first data protection scheme comprising a first data format including a first portion having parity bits associated with an error correction code ECC and a second portion having the system critical data, the second data protection scheme comprising a second data format including a third portion having metadata for wear management of the non-volatile memory, a fourth portion having parity bits associated with the ECC and a fifth portion having the user data, the first portion of the first data format having more parity bits compared to parity bits for the fourth portion of the second data format.

6. The method of claim 1, the first data protection scheme comprising:
causing first and second copies of the system critical data to be written to the non-volatile memory;
maintaining a first drift timer for the first copy and a second drift timer for the second copy, the first drift timer to expire after a first period of time and the second drift timer to expire after a second period of time, the first period of time being different than the second period of time;
causing the first copy to be refreshed following expiration of the first drift timer; and
causing the second copy to be refreshed following expiration of the second drift timer.

7. The method of claim 1, causing system critical data to be written to the non-volatile memory comprising causing system critical data to be written using a multiple pulse-verification process capable of narrowing threshold voltage distributions for memory cells associated with the non-volatile memory where the system critical data is stored.

8. An apparatus (900) comprising:
a processor circuit (920);
a system critical data component (922-1) arranged for execution by the processor circuit to receive a first write request for writing system critical data to a non-volatile memory (120) and cause the system critical data, once encoded, to be written to the non-volatile memory using a first data protection scheme having a given data format size;
a user data component (922-2) arranged for execution by the processor circuit to receive a second write request for writing user data that includes non-system critical data to the non-volatile memory and cause the user data, once encoded, to be written to the non-volatile memory using a second data protection scheme having a same given data format size as system critical data written to the non-volatile memory according to the first data protection scheme;
an encode component (922-3) arranged for execution by the processor circuit to encode the received system critical data according to the first data protection scheme and encode the received user data according to the second data protection scheme;
a decode component (922-4) arranged for execution by the processor circuit to decode the encoded system critical data responsive to a first read request for the encoded system critical data or to decode the encoded user data responsive to a second read request for the encoded user data; and
the system critical data component arranged to use the first data protection scheme comprises use of a Reed-Solomon error correction code (ECC) capable of having four separate Reed-Solomon codewords having overlapping system critical data.

9. The apparatus of claim 8, the non-volatile memory being part of a memory device (100) comprising one of a two level memory (2LM) device or a solid state drive (SSD) device and the system critical data comprising data that if unreadable after being written to the non-volatile memory render the memory device or a computing device (1200) using the memory device non-functional.

10. The apparatus of claim 8, use of the first data protection scheme and the second data protection scheme comprises use of a Reed-Solomon error correction code (ECC), the use of the Reed-Solomon ECC for the second data protection scheme having a code format of (n, k), where n equals a size of a codeword and k equals a size of information to be encoded, the use of the Reed-Solomon ECC for the first data protection scheme having a code format of (n-s,k-s), where s equals a shortening of the information to be encoded.

11. The apparatus of claim 8, use of the first data protection scheme and the second data protection scheme comprises use of a Reed-Solomon error correction code (ECC), the use of the Reed-Solomon ECC for the second data protection scheme having a first code format of (n, k), where n equals a size of a codeword and k equals a size of information to be encoded, the use of the Reed-Solomon ECC for the first data protection scheme having a second code format of (n/2,k/2), where information in the first code format is encoded in a first portion and the same information is redundantly encoded in a second portion.

12. The apparatus of claim 8, the first data protection scheme comprising a first data format including a first portion having parity bits associated with an error correction code (ECC) and a second portion having the system critical data, the second data protection scheme comprising a second data format including a third portion having metadata for wear management of the non-volatile memory, a fourth portion having parity bits associated with the ECC and a fifth portion having the user data, the first portion of the first data format having more parity bits compared to parity bits for the fourth portion of the second data format.

## Patentansprüche

1. Verfahren, das Folgendes umfasst:
Empfangen (1002) einer ersten Schreibanfrage zum Schreiben von systemkritischen Daten in einen nichtflüchtigen Speicher (120);
Veranlassen (1004, 1006) des Codierens und Schreibens von systemkritischen Daten in den nichtflüchtigen Speicher unter Verwendung einer ersten Datenschutzregelung, die eine gegebene Datenformatgröße hat; und
Empfangen (1008) einer zweiten Schreibanfrage zum Schreiben von Benutzerdaten, die nicht systemkritische Daten enthalten, in den nichtflüchtigen Speicher; **gekennzeichnet durch**
Veranlassen (1010, 1012) des Codierens und Schreibens der Benutzerdaten in den nichtflüchtigen Speicher unter Verwendung einer zweiten Datenschutzregelung, die eine gleiche gegebene Datenformatgröße wie die systemkritischen Daten hat, die gemäß der ersten Datenschutzregelung in den nichtflüchtigen Speicher geschrieben werden; und
wobei die erste Datenschutzregelung den Gebrauch eines Reed-Solomon-Fehlerkorrekturcodes (ECC) umfasst, der vier getrennte Reed-Solomon-Codewörter verwendet, die überlappende systemkritische Daten aufweisen.

2. Verfahren nach Anspruch 1, wobei der nichtflüchtige Speicher Teil einer Speichervorrichtung (100) ist, die entweder eine Two-Level-Memory-(2LM)-Vorrichtung oder eine Solid-State-Drive (SSD)-Vorrichtung umfasst, wobei die systemkritischen Daten Daten umfassen, die, falls sie unlesbar sind, nachdem sie in den nichtflüchtigen Speicher geschrieben worden sind, die Speichervorrichtung oder eine Rechenvorrichtung (1200), welche die Speichervorrichtung verwendet, funktionsuntüchtig machen.

3. Verfahren nach Anspruch 1, das die erste Datenschutzregelung und die zweite Datenschutzregelung umfasst, die beide den Gebrauch eines Reed-Solomon-Fehlerkorrekturcodes (ECC) beinhalten, wobei der Gebrauch des Reed-Solomon-ECC für die zweite Datenschutzregelung ein Codeformat von (n, k) aufweist, bei dem n einer Größe eines Codeworts und k einer Größe der zu codierenden Informationen entspricht, wobei der Gebrauch des Reed-Solomon-ECC für die erste Datenschutzregelung ein Codeformat von (n-s, k-s) aufweist, bei dem s einer Abkürzung der zu codierenden Informationen entspricht.

4. Verfahren nach Anspruch 1, das die erste Datenschutzregelung und die zweite Datenschutzregelung umfasst, die beide den Gebrauch eines Reed-Solomon-Fehlerkorrekturcodes (ECC) beinhalten, wobei der Gebrauch des Reed-Solomon-ECC für die zweite Datenschutzregelung ein erstes Codeformat von (n, k) aufweist, bei dem n einer Größe eines Codeworts und k einer Größe der zu codierenden Informationen entspricht, wobei der Gebrauch des Reed-Solomon-ECC für die erste Datenschutzregelung ein zweites Codeformat von (n/2, k/2) aufweist, bei dem Informationen im zweiten Codeformat in einem ersten Teil codiert werden und dieselben Informationen redundant in einem zweiten Teil codiert werden.

5. Verfahren nach Anspruch 1, wobei die erste Datenschutzregelung ein erstes Datenformat umfasst, das einen ersten Teil enthält, der Paritätsbits aufweist, die mit einem Fehlerkorrekturcode (ECC) verknüpft sind, und einen zweiten Teil, der die systemkritischen Daten aufweist, wobei die zweite Datenschutzregelung ein zweites Datenformat umfasst, das einen dritten Teil enthält, der Metadaten für Verschleißmanagement des nichtflüchtigen Speichers aufweist, wobei ein vierter Teil Paritätsbits aufweist, die mit dem ECC verknüpft sind, und ein fünfter Teil die Benutzerdaten aufweist, wobei der erste Teil des ersten Datenformats mehr Paritätsbits aufweist, verglichen mit den Paritätsbits für den vierten Teil des zweiten Datenformats.

6. Verfahren nach Anspruch 1, wobei die erste Datenschutzregelung Folgendes umfasst:
Veranlassen des Schreibens von ersten und zweiten Kopien der systemkritischen Daten in den nichtflüchtigen Speicher;
Aufrechterhalten eines ersten Drifttimers für die erste Kopie und eines zweiten Drifttimers für die zweite Kopie, wobei der erste Drifttimer nach einem ersten Zeitraum abläuft, und der zweite Drifttimer nach einem zweiten Zeitraum abläuft, wobei der erste Zeitraum anders als der zweite Zeitraum ist;
Veranlassen der Aktualisierung der ersten Kopie nach dem Ablauf des ersten Drifttimers; und
Veranlassen der Aktualisierung der zweiten Kopie nach dem Ablauf des zweiten Drifttimers.

7. Verfahren nach Anspruch 1, das veranlasst, dass systemkritische Daten in den nichtflüchtigen Speicher geschrieben werden, wobei das Verfahren Veranlassen des Schreibens von systemkritischen Daten unter Verwendung eines Mehrfachimpuls-Überprüfungsprozesses umfasst, der fähig ist, Schwellenspannungsverteilungen für Speicherzellen zu verengen, die mit dem nichtflüchtigen Speicher verknüpft sind, in dem die systemkritischen Daten gespeichert sind.

8. Vorrichtung (900), die Folgendes umfasst:
eine Prozessorschaltung (920);
eine Komponente für systemkritische Daten (922-1), die zur Ausführung durch die Prozessorschaltung angeordnet ist, eine erste Schreibanfrage zum Schreiben von systemkritischen Daten in einen nichtflüchtigen Speicher (120) zu empfangen und zu veranlassen, dass die systemkritischen Daten, nachdem sie codiert worden sind, in den nichtflüchtigen Speicher geschrieben werden, und zwar unter Verwendung einer ersten Datenschutzregelung, die eine gegebene Datenformatgröße aufweist;
eine Komponente für Benutzerdaten (922-2), die zur Ausführung durch die Prozessorschaltung angeordnet ist, eine zweite Schreibanfrage zum Schreiben von Benutzerdaten, die nicht systemkritische Daten enthalten, in den nichtflüchtigen Speicher zu empfangen und zu veranlassen, dass die Benutzerdaten, nachdem sie codiert worden sind, in den nichtflüchtigen Speicher geschrieben werden, unter Verwendung einer zweiten Datenschutzregelung, die eine gleiche gegebene Datenformatgröße wie die systemkritischen Daten aufweist, die gemäß der ersten Datenschutzregelung in den nichtflüchtigen Speicher geschrieben wurden;
eine Codierkomponente (922-3), die zur Ausführung durch die Prozessorschaltung angeordnet ist, die empfangenen systemkritischen Daten gemäß der ersten Datenschutzregelung zu codieren, und die empfangenen Benutzerdaten gemäß der zweiten Datenschutzregelung zu codieren;
eine Decodierkomponente (922-4), die zur Ausführung durch die Prozessorschaltung angeordnet ist, die codierten systemkritischen Daten in Reaktion auf eine erste Leseanfrage für die codierten systemkritischen Daten zu decodieren, oder die codierten Benutzerdaten in Reaktion auf eine zweite Leseanfrage für die codierten Benutzerdaten zu decodieren; und
wobei die Komponente für systemkritische Daten, die angeordnet ist, um die erste Datenschutzregelung zu verwenden, den Gebrauch eines Reed-Solomon-Fehlerkorrekturcodes (ECC) umfasst, der vier getrennte Reed-Solomon-Codewörter verwendet, die überlappende systemkritische Daten aufweisen.

9. Vorrichtung nach Anspruch 8, wobei der nichtflüchtige Speicher Teil einer Speichervorrichtung (100) ist, die entweder eine Two-Level-Memory-(2LM)-Vorrichtung oder eine Solid-State-Drive (SSD)-Vorrichtung umfasst, wobei die systemkritischen Daten Daten umfassen, die, falls sie unlesbar sind, nachdem sie in den nichtflüchtigen Speicher geschrieben worden sind, die Speichervorrichtung oder eine Rechenvorrichtung (1200), welche die Speichervorrichtung verwendet, funktionsuntüchtig machen.

10. Vorrichtung nach Anspruch 8, deren Gebrauch der ersten Datenschutzregelung und der zweiten Datenschutzregelung den Gebrauch eines Reed-Solomon-Fehlerkorrekturcodes (ECC) umfasst, wobei der Gebrauch des Reed-Solomon-ECC für die zweite Datenschutzregelung ein Codeformat von (n, k) aufweist, bei dem n einer Größe eines Codeworts und k einer Größe der zu codierenden Informationen entspricht, wobei der Gebrauch des Reed-Solomon-ECC für die erste Datenschutzregelung ein Codeformat von (n-s, k-s) aufweist, bei dem s einer Abkürzung der zu codierenden Informationen entspricht.

11. Vorrichtung nach Anspruch 8, deren Gebrauch der ersten Datenschutzregelung und der zweiten Datenschutzregelung den Gebrauch eines Reed-Solomon-Fehlerkorrekturcodes (ECC) umfasst, wobei der Gebrauch des Reed-Solomon-Fehlerkorrekturcodes (ECC) für die zweite Datenschutzregelung ein erstes Codeformat von (n, k) aufweist, bei dem n einer Größe eines Codeworts und k einer Größe der zu codierenden Informationen entspricht, wobei der Gebrauch des Reed-Solomon-ECC für die erste Datenschutzregelung ein zweites Codeformat von (n/2, k/2) aufweist, bei dem Informationen im ersten Codeformat in einem ersten Teil codiert werden und dieselben Informationen redundant in einem zweiten Teil codiert werden.

12. Vorrichtung nach Anspruch 8, wobei die erste Datenschutzregelung ein erstes Datenformat umfasst, das einen ersten Teil enthält, der Paritätsbits aufweist, die mit einem Fehlerkorrekturcode (ECC) verknüpft sind, und einen zweiten Teil, der die systemkritischen Daten aufweist, wobei die zweite Datenschutzregelung ein zweites Datenformat umfasst, das einen dritten Teil enthält, der Metadaten für Verschleißmanagement des nichtflüchtigen Speichers aufweist, wobei ein vierter Teil Paritätsbits aufweist, die mit dem ECC verknüpft sind, und ein fünfter Teil die Benutzerdaten aufweist, wobei der erste Teil des ersten Datenformats mehr Paritätsbits aufweist, verglichen mit den Paritätsbits für den vierten Teil des zweiten Datenformats.

## Revendications

1. Procédé consistant :
à recevoir (1002) une première demande d'écriture pour écrire des données critiques pour le système dans une mémoire non volatile (120) ;
à provoquer (1004, 1006) le codage et l'écriture de données critiques pour le système dans la mémoire non volatile à l'aide d'un premier schéma de protection de données ayant une taille de format de données donnée ; et
à recevoir (1008) une seconde demande d'écriture pour écrire des données d'utilisateur qui comprennent des données non critiques pour le système, dans la mémoire non volatile, **caractérisé en ce qu'**il consiste
à provoquer (1010, 1012) le codage et l'écriture de données d'utilisateur dans la mémoire non volatile à l'aide d'un second schéma de protection de données ayant une même taille de format de données donnée que celle des données critiques pour le système écrites dans la mémoire non volatile selon le premier schéma de protection de données ; et
le premier schéma de protection de données comprenant l'utilisation d'un code de correction d'erreur (ECC) de Reed-Solomon qui utilise quatre mots codés de Reed-Solomon distincts ayant des données critiques pour le système qui se chevauchent.

2. Procédé selon la revendication 1, la mémoire non volatile faisant partie d'un dispositif de mémoire (100) comprenant soit un dispositif de mémoire à deux niveaux (2LM), soit un dispositif de disque statique à semiconducteurs (SSD), les données critiques pour le système comprenant des données qui, si elles sont illisibles après avoir été écrites dans la mémoire non volatile, rendent le dispositif de mémoire ou un dispositif informatique (1200) utilisant le dispositif de mémoire non fonctionnel.

3. Procédé selon la revendication 1, comprenant le premier schéma de protection de données et le second schéma de protection de données comprenant l'un et l'autre l'utilisation d'un code de correction d'erreur (ECC) de Reed-Solomon, l'utilisation du code ECC de Reed-Solomon pour le second schéma de protection de données ayant un format de code de (n, k), où n est égal à une taille d'un mot codé et k est égal à une taille d'informations à coder, l'utilisation du code ECC de Reed-Solomon pour le premier schéma de protection de données ayant un format de code de (n - s, k - s), où s est égal à une réduction des informations à coder.

4. Procédé selon la revendication 1, comprenant le premier schéma de protection de données et le second schéma de protection de données comprenant l'un et l'autre l'utilisation d'un code de correction d'erreur (ECC) de Reed-Solomon, l'utilisation du code ECC de Reed-Solomon pour le second schéma de protection de données ayant un premier format de code de (n, k), où n est égal à une taille d'un mot codé et k est égal à une taille d'informations à coder, l'utilisation du code ECC de Reed-Solomon pour le premier schéma de protection de données ayant un second format de code de (n/2, k/2), où des informations dans le second format de code sont codées dans une première partie et les mêmes informations sont codées de manière redondante dans une deuxième partie.

5. Procédé selon la revendication 1, le premier schéma de protection de données comprenant un premier format de données comprenant une première partie ayant des bits de parité associés à un code de correction d'erreur (ECC) et une deuxième partie ayant les données critiques pour le système, le second schéma de protection de données comprenant un second format de données comprenant une troisième partie ayant des métadonnées pour une gestion d'usure de la mémoire non volatile, une quatrième partie ayant des bits de parité associés au code ECC et une cinquième partie ayant les données d'utilisateur, la première partie du premier format de données ayant davantage de bits de parité par comparaison avec les bits de parité de la quatrième partie du second format de données.

6. Procédé selon la revendication 1, le premier schéma de protection de données consistant :
à provoquer l'écriture des première et seconde copies des données critiques pour le système dans la mémoire non volatile ;
à conserver un premier temporisateur de dérive pour la première copie et un second temporisateur de dérive pour la seconde copie, le premier temporisateur de dérive étant destiné à expirer après une première période de temps et le second temporisateur de dérive étant destiné à expirer après une seconde période de temps, la première période de temps étant différente de la seconde période de temps ;
à provoquer le rafraîchissement de la première copie après l'expiration du premier temporisateur de dérive ; et
à provoquer le rafraîchissement de la seconde copie après l'expiration du second temporisateur de dérive.

7. Procédé selon la revendication 1, le fait de provoquer l'écriture de données critiques pour le système dans la mémoire non volatile consiste à provoquer l'écriture de données critiques pour le système à l'aide d'un processus de vérification de multiples impulsions qui peut limiter des distributions de tension de seuil pour des cellules de mémoire associées à la mémoire non volatile lorsque les données critiques pour le système sont stockées.

8. Appareil (900) comprenant :
un circuit de processeur (920) ;
un composant de données critiques pour le système (922-1) conçu pour une exécution par le circuit de processeur pour recevoir une première demande d'écriture pour écrire des données critiques pour le système dans une mémoire non volatile (120) et pour provoquer l'écriture de données critiques pour le système, une fois qu'elles sont codées, dans la mémoire non volatile à l'aide d'un premier schéma de protection de données ayant une taille de format de données donnée ;
un composant de données d'utilisateur (922-2) conçu pour une exécution par le circuit de processeur pour recevoir une seconde demande d'écriture pour écrire des données d'utilisateur qui comprennent des données non critiques pour le système, dans la mémoire non volatile et pour provoquer l'écriture de données d'utilisateur, une fois qu'elles sont codées, dans la mémoire non volatile à l'aide d'un second schéma de protection de données ayant une même taille de format de données donnée que celle des données critiques pour le système écrites dans la mémoire non volatile selon le premier schéma de protection de données ;
un composant de codage (922-3) conçu pour une exécution par le circuit de processeur pour coder les données critiques pour le système reçues selon le premier schéma de protection de données et pour coder les données d'utilisateur reçues selon le second schéma de protection de données ;
un composant de décodage (922-4) conçu pour une exécution par le circuit de processeur pour décoder les données critiques pour le système codées en réponse à une première demande de lecture pour les données critiques pour le système codées ou pour décoder les données d'utilisateur codées en réponse à une seconde demande de lecture pour les données d'utilisateur codées ; et
le composant de données critiques pour le système conçu pour utiliser le premier schéma de protection de données comprend l'utilisation d'un code de correction d'erreur (ECC) de Reed-Solomon qui peut avoir quatre mots codés de Reed-Solomon distincts ayant des données critiques pour le système qui se chevauchent.

9. Appareil selon la revendication 8, la mémoire non volatile faisant partie d'un dispositif de mémoire (100) comprenant soit un dispositif de mémoire à deux niveaux (2LM), soit un dispositif de disque statique à semiconducteurs (SSD) et les données critiques pour le système comprenant des données qui, si elles sont illisibles après avoir été écrites dans la mémoire non volatile, rendent le dispositif de mémoire ou un dispositif informatique (1200) utilisant le dispositif de mémoire non fonctionnel.

10. Appareil selon la revendication 8, l'utilisation du premier schéma de protection de données et du second schéma de protection de données comprend l'utilisation d'un code de correction d'erreur (ECC) de Reed-Solomon, l'utilisation du code ECC de Reed-Solomon pour le second schéma de protection de données ayant un format de code de (n, k), où n est égal à une taille d'un mot codé et k est égal à une taille d'informations à coder, l'utilisation du code ECC de Reed-Solomon pour le premier schéma de protection de données ayant un format de code de (n - s, k - s), où s est égal à une réduction des informations à coder.

11. Appareil selon la revendication 8, l'utilisation du premier schéma de protection de données et du second schéma de protection de données comprend l'utilisation d'un code de correction d'erreur (ECC) de Reed-Solomon, l'utilisation du code ECC de Reed-Solomon pour le second schéma de protection de données ayant un premier format de code de (n, k), où n est égal à une taille d'un mot codé et k est égal à une taille d'informations à coder, l'utilisation du code ECC de Reed-Solomon pour le premier schéma de protection de données ayant un second format de code de (n/2, k/2), où des informations dans la premier format de code sont codées dans une première partie et les mêmes informations sont codées de manière redondante dans une deuxième partie.

12. Appareil selon la revendication 8, le premier schéma de protection de données comprenant un premier format de données comprenant une première partie ayant des bits de parité associés à un code de correction d'erreur (ECC) et une deuxième partie ayant les données critiques pour le système, le second schéma de protection de données comprenant un second format de données comprenant une troisième partie ayant des métadonnées pour une gestion d'usure de la mémoire non volatile, une quatrième partie ayant des bits de parité associés au code ECC et une cinquième partie ayant les données d'utilisateur, la première partie du premier format de données ayant davantage de bits de parité par comparaison avec les bits de parité de la quatrième partie du second format de données.
